# EUROPEAN PATENT APPLICATION

(11) **EP 1 524 553 A2**
(43) Date of publication of application: **20.04.2005**
(21) Application number: 04256113.4
(22) Date of filing: 02.10.2004
(51) Int. Cl.: G03F 7/00, G03F 7/16

(54) **Pattern formation**

(30) Priority: 15.10.2003 US 511395 P
(71) Applicant: Rohm and Haas Electronic Materials, L.L.C., Marlborough, Massachusetts 01752 (US)
(72) Inventor: Barr, Robert K., Shrewsbury Massachusetts 01545 (US); Knudsen, Philip D., Northboro Massachusetts 01532 (US); Sutter, Thomas C., Holden Massachusetts 01520 (US)
(74) Representative: Kent, Venetia Katherine

(57) **Abstract**

A repelling barrier composition is selectively applied to a substrate followed by applying a radiant energy sensitive material to spaces or channels formed by the barrier composition. The repellent barrier composition repels the radiant energy sensitive material such that it is directed into the spaces or channels formed by the barrier composition. The repellent barrier composition is removed to form a pattern on the substrate.

## Description

### Background of the Invention

The present invention is directed to pattern formation on a substrate. More specifically, the present invention is directed to pattern formation on a substrate using a composition that repels radiant energy sensitive materials.

Methods of forming patterns on substrates encompass various industries such as the electronics, graphic arts and textile industries. Forming patterns or images typically involves lithography or photolithography. For example printed fabric labels may be made using a variety of techniques, such as screen printing, offset lithography printing, dyeing, flexographic printing, in-plant printing, and transfer printing. Such labels are suitable for garments for the purpose of decoration, identification, advertising, wash and care instructions, size, price, as well as other purposes.

Screen printing, also known as silk screen, employs a porous stencil mounted on a screen, in which the non-printing areas are protected by the stencil. The masking material also may be dried lacquer, shellac or glue. Printing is done on a mechanized press by feeding cloth under the screen, applying ink with a paint-like consistency to the screen, and spreading and forcing it through the fine mesh openings with a squeegee.

In the offset lithography method, the image and non-image areas are essentially on the same plane of the surface of a thin metal plate, the definition between them being maintained chemically. The ink is picked up by the hydrophobic areas on the plate but is not picked up by the hydrophilic areas. The image is then transferred to an offset rubber roll, then from the roll to the fabric sheet.

Flexographic printing is a form of rotary letterpress using flexible rubber plates and fast-drying fluid inks. The rubber plates utilize the relief method for image creation, where the image area is raised above the non-image areas. Ink rollers only touch the top surface of the raised area. The surrounding, non-printing, areas are lower and do not receive ink. The inked image is transferred directly to a cloth. Dyeing can be achieved by using dyestuffs rather than pigmented inks in any of the printing processes described above. The use of dyes, however, requires additional after treatments to fix the dye in the fabric.

There are three types of transfer printing. One type is wet transfer printing, another is thermacrome or melt transfer printing and the third is dry transfer, vapor phase transfer or sublimation transfer. In dry transfer printing, designs are printed using a variety of techniques such as letterpress, flexographic gravure, rotary screen or offset lithography.

In wet transfer printing a paper carrier sheet is printed with a design using a gravure printing technique with a wide variety of dye classes, such as vat, acid and direct dyes, and acetate dispersed dyestuffs. The printing inks contain thermoplastic components. When the printed paper is brought in contact with the fabric, transfer of the print from the paper to the fabric is effected by applying heat and pressure. The prints on the fabric are then treated with steam to set the dyestuffs followed by washing to remove thickeners. Such aftertreatments are those employed in conventional techniques for dyeing fabrics.

In thermacrome a design is printed onto a carrier paper with a transfer of the printed design to a fabric, the printed paper is heated in contact with the fabric whereupon the resin melts and is partially transferred to the fabric substrate. Such prints do not require an aftertreatment.

In dry transfer a heat resistant carrier such as paper is printed with inks containing sublimable dyestuffs. The printed paper is then placed in contact with a fabric surface. When heat and pressure are applied to the back of the paper, the dues sublime from the ink on the paper, diffuse across the air gap to the surface of the fibers in the fabric, condense on the fibers and then diffuse into the interiors of the fibers.

Transfer printing techniques as well as the other methods described above are unsuitable for printing directly on fabric labels. Transfer papers must first be printed with the characters or design, which are to be transferred to the labels. Preprinting is usually done off site in large volume to be economic. In order to ensure that each garment receives the proper labeling which is required, a large inventory of different labels is maintained. If the printing is to be done in-plant, an equally large inventory of different preprinted transfer papers is required. Further, printing rollers are very expensive and slow to produce. Accordingly, there is a need for an improved method for forming a pattern on fabric.

In the electronics industry patterns are formed on substrates for the formation of circuitry by photolithography. This involves the use of a radiant energy sensitive material, such as photosensitive material, that is applied to a surface as a whole area coating (spin-casting or dipping) or as a whole area sheet (lamination). The material is applied in a light controlled laboratory in order to ensure that the photosensitive material is not pre-exposed prior to introducing the required pattern mask in front of the coated wafer. The patterning mask can be either a contact mask, a proximity mask or a projection mask. In all cases the mask is manufactured as a discrete unit to a high precision and is carefully protected against damage or dust/particulate collection. Once the mask is put in place then a lamp, of a radiation material matched to a photoinitiator used in the photosensitive material, may be used to expose the substrate coating in those areas not protected by the mask. Depending upon the photosensitive material type employed the pattern transfer achieved may be either positive or negative with respect to the mask. After exposure the photosensitive material must be exposed to a developing chemical that modifies the chemistry of the coating in such a manner as to permit the untreated material to be washed away in a water-based dip bath or conveyor shower/spray.

Although spin-cast, dip, or sheet lamination photolithographic methods of achieving a surface relief pattern are successful, they do have a number of problems such as material wastage (because of whole area technique), selective 3-D patterning is difficult and time consuming, chemistry used in photosensitive material has a high toxicity rating, disposability of large volumes of toxic and developing chemicals, and simple patterning is a multiple step process such as photocoating, mask alignment, radiation exposure, mask removal, pattern development, excess material rinse removal, and substrate drying.

Although one or more of these problems may be addressed by introducing further processes that can provide a patterned relief structure on a surface, including stenciling (screen printing), microdot transfer (stamping), and laser writing-etching (includes ablation scribing and direct-write photolithography equivalent imaging). Each technique has its merits and limitations which are driven by the detail of the intended application such as speed pattern generations, relief pattern thickness, controlled etch capability, cost of process and ease of use process. However, any one process can not address all of the problems cited above.

Many methods used in the manufacture of electronic devices require selective application of a photosensitive material, which is then used to enable subsequent steps of the overall manufacturing process. For example, solder mask is excluded from through-holes in a printed wiring board but is present in other areas of the board which require resistance to solder applied later in the manufacturing process.

A variety of methods are currently practiced that enable the selective final presence of solder mask or other photosensitive material. Many of the current methods are hampered with a combination of technical, environmental, cost or efficiency related issues. For example, solder mask is patterned to fully cover electronic circuitry except for those portions intended to be exposed, e.g., for soldering to another component. Solder masks are typically formed from a layer of photosensitive composition which is applied to a substrate of a printed circuit board. The photosensitive layer is exposed to actinic radiation, which is patterned by means of an artwork. Subsequent to exposure, the photosensitive layer is developed in a solvent which washes away either exposed or unexposed portions of the layer (depending upon whether the photosensitive material is positive acting or negative acting). The portion of the layer which remains on the substrate is then cured, e.g., with heat or UV light to form a hard, permanent solder mask intended to protect the printed circuitry. Such processes waste significant amounts of materials in developing solutions. Also, consuming developing solutions, producing chemical waste from the used developing solutions (treated and disposed of), processing steps such as exposure and development result in inefficiency, environmental, and expense issues.

Another problem is registration. Registration is the relative position of one or more printed wiring patterns or portions thereof with respect to desired locations on a printed wiring board or another pattern on the other side of the board. One of the challenges in the manufacture of multi-layer printed wiring boards is to obtain adequate innerlayer registration. Internal features must be registered accurately to each other, and they must be accurately registered to any drilled holes. Hole-to-innerlayer misregistration creates two potential reliability problems: failure of the hole to line connection and shorts between holes and isolated conductors. Misregistration of internal layers also increases electrical resistance and decreases conductivity. Severe misregitration creates an open-circuit condition, a complete loss of continuity. Many conventional methods of addressing registration problems are both slow and costly. For example, optical registration using either operator expertise or automatic registration from registration marks (fiducials) on the board that are recognized and corrected automatically have been used. The difficulty arises with respect to solder mask due to the fact that solder mask is the last outerlayer process on a board. All dimensional to that point have been additive, which leads to the need for larger features to accommodate previous dimensional change in the board. This is due to the fact that visual or optical alignment can only accommodate a limited amount of dimensional change in the board.

Accordingly, there is a need for improved methods of forming a pattern on a substrate.

### Summary of the Invention

A method includes applying a repelling barrier selectively to a substrate; applying a radiant energy sensitive material to the substrate in spaces formed by the repelling barrier; and removing the repelling barrier to form a pattern on the substrate.

In another embodiment the method includes applying a repelling barrier selectively to a substrate; applying a photosensitive material to the substrate in spaces formed by the repelling barrier; exposing the photosensitive material to radiant energy; and removing the repelling barrier to form a pattern on the substrate.

In a further embodiment the method includes applying a repelling barrier selectively to a substrate; applying a photosensitive material to the substrate in spaces formed by the repelling barrier; exposing the photosensitive material to actinic radiation; removing the repelling barrier to form a pattern on the substrate.

In an additional embodiment the method includes applying a repelling barrier selectively to a substrate; applying a photosensitive material to the substrate in spaces formed by the repelling barrier; exposing the photosensitive material to actinic radiation; removing the repelling barrier to form a pattern on the substrate; and depositing one or more metal layers in spaces formed by the pattern.

In still yet another embodiment the repelling barrier is a composition that repels radiant energy sensitive material physically, electrolytically or chemically.

Forming a pattern on a substrate using a selectively applied repelling barrier reduces both chemical waste and processes steps, thus both cost and productivity can be improved. Also, reduction of chemical waste reduces the amount of waste that must be treated. Accordingly, the methods of pattern formation using a repelling barrier are more environmentally friendly than many conventional methods.

Further, registration problems, which are difficult to correct using many conventional techniques, may be efficiently addressed by the methods and compositions of the invention.

### Detailed Description of the Invention

As used throughout this specification, the following abbreviations have the following meanings, unless the context indicates otherwise: °C = degrees Centigrade; gm = grams; L = liters; mL = milliliters; wt% = percent by weight; cp = centipoises; kV = kilovolts; psi = pounds per square inch; mJ = milliJoules; cm = centimeters.

The terms "printed wiring board" and "printed circuit board" are used interchangeably throughout this specification. "Depositing" and "plating" are used interchangeably throughout this specification and include both electroless plating and electrolytic plating. "Multi-layer" refers to two or more layers. "Polymer" and "copolymer" are used interchangeably throughout the specification. "Radiant energy" means energy from light or thermal energy. "Actinic radiation" means radiation from light that produces a chemical change. "(Alky)acrylate" includes both "acrylates" and "alkyacrylates". "Viscosity = internal fluid friction or the ratio of the shear stress to the rate of shear of a fluid. "Pseudoviscosity" = viscosity of a thixotropic substance in its most viscous state. "adjuvant" = an additive in a mixture which contributes to the effectiveness of primary ingredients.

All percentages are by weight, unless otherwise noted. All numerical ranges are inclusive and combinable in any order, except where it is logical that such numerical ranges are constrained to add up to 100%.

A repelling barrier is selectively applied to a substrate, a radiant energy sensitive material is then applied to the substrate in spaces formed by the selective application of the repelling barrier material, and the repelling barrier material is removed to form a pattern on the substrate. The pattern may be permanent or temporary. In either case, the substrate may be further processed. Articles made using the methods include electronic devices, printed images on paper, and images printed on a fabric or fabric label.

The repelling barrier may be selectively applied to a substrate by any suitable means such that the repelling barrier material forms spaces or channels for the application of a radiant energy sensitive material. Examples of such radiant energy sensitive material include, but are not limited to, resists and inks. Resists include photosensitive materials such as photoresists, and plating resists. Such materials have pseudoviscosities prior to exposure to radiation of less than 10,000 cp, or such as from 1 cp to 5,000 cp, or such as from 200 cp to 1,000 cp. Methods of applying a repelling barrier composition include, but are not limited to, ink-jet application, roller coating, spin coating and electrostatic coating.

Any suitable ink-jet apparatus may be employed to selectively apply a repelling barrier composition to a substrate. Ink-jet apparatus may digitally store information in its memory for a selective repelling barrier design to be applied to the substrate, thus the repelling barrier may be selectively and directly applied to the substrate without intervening steps. Examples of suitable computer programs are standard CAD computer programs for generation of tooling data. Additionally, changes in the selective deposition of the repelling barrier material may be readily modified by changing the program digitally stored in the ink-jet apparatus. Accordingly, efficiency of selective deposition of the repelling barrier and patterns formed of the radiant energy sensitive material is increased over many conventional methods.

There are two major categories of ink-jet printing, "Drop-On-Demand" ink-jet and "Continuous" ink-jet. Using Drop-On-Demand ink jet technology the barrier material is stored in a reservoir and delivered to a nozzle in the print head of the printer. A means exists to force a single drop of barrier material out of the nozzle and onto a substrate. Typically, this is a piezoelectric actuation of a diaphragm within a chamber, which "pumps" the repelling barrier composition droplet out of the nozzles, or a localized heating of the fluid to increase pressure within the chamber, thus forcing a droplet to jet. For continuous ink jet a conducting barrier material is supplied under pressure to an ink nozzle and forced out through a small orifice, typically 35 µm to 80 µm in diameter. Prior to passing out of the nozzle, the pressurized barrier composition stream proceeds through a ceramic crystal, which is subjected to an electric current. This current causes a piezoelectric vibration equal to the frequency of AC (alternating current) electric current. This vibration, in turn, generates droplets of the barrier composition from the unbroken stream. The barrier composition breaks up into a continuous series of drops, which are equally spaced and of equal size. Surrounding the jet at the point where the drops separate from the liquid stream in a charge electrode a voltage is applied between the charge electrode and the drop stream. When the drops break off from the stream, each drop carries a charge proportional to the applied voltage at the instant at which it breaks off. By varying the charge electrode voltages at the same rate as drops are produced every drop may be charged to a predetermined level. The drop stream continues its flight and passes between two deflector plates, which are maintained at a constant potential such as +/- 0.1 kV to +/- 5 KV, or such as +/- 1 kV to +/- 3 kV. In the presence of this field, a drop is deflected towards one of the plates by an amount proportional to the charge carried. Drops, which are uncharged, are undeflected and collected into a gutter to be recycled to the ink nozzle. Drops, which are charged and hence deflected, impinge on a substrate traveling at right angles to the direction of drop deflection. By varying the charge on individual drops, the desired pattern can be applied. Drop sizes may range from 30 µm to 100 µm, or such as from 40 µm to 80 µm, or such as from 50 µm to 70 µm in diameter.

The ink-jet processes are adaptable to computer control for high speed application of continuously variable data. Continuous ink jet printing methods may be divided into three general categories: high pressure (10 psi and greater), low pressure (less than 10 psi) and vacuum techniques. All are known in the art or described in the literature and can be employed in the application of repelling barrier materials to substrates.

Repelling barrier materials that may be applied by ink-jet include, but are not limited to, compositions containing waxes, polymers and copolymers. Repelling barrier materials also may be resists. Such repelling barrier materials have melting temperatures in ink-jet apparatus of from 95° C to 200° C, or such as from 100° C to 150° C, or such as from 110° C to 130° C.

Examples of suitable waxes include, but are not limited to, paraffin wax such as straight-chain hydrocarbons with 26-30 carbon atoms/molecule; microcrystalline wax such as branched-chain hydrocarbons with 41-50 carbon atoms/molecule; oxidized microcrystalline waxes such as hydrocarbons, esters, fatty acids; montan waxes such as wax acids, alcohols, esters, and ketones; ceresin wax; Hoechst waxes such as acids, and esters (obtained by oxidizing montan wax); ozocerite waxes such as saturated and unsaturated high molecular weight hydrocarbons, i.e. greater than 5000 daltons; carnauba waxes such as complex alcohols, hydrocarbons, and resins, Japan wax, and bayberry wax; esparto waxes such as hydrocarbons; sugarcane waxes such as hydrocarbons, long straight-chain aldehydes and alcohols; candelilla waxes such as hydrocarbons, acids, esters, alcohols, stearols and resins; animal waxes such as beeswax, which includes hydrocarbons, acids, esters, alcohols and lactones, shellac wax, and spermaceti wax; synthetic waxes such as Fischer-Tropsch waxes, which includes saturated and unsaturated hydrocarbons, and oxygen compounds. Other suitable waxes include polyethylene, polypropylene, fatty acid amide and polytetrafluroethylene waxes. The waxes described above may be used individually or may be mixed together.

Polymers and copolymers, which may be applied to a substrate by ink-jet include, but are not limited to, polyolefins, polycaprolactones, polyamines, thixotropic polymers, amorphous and semi-crystalline thermoplastic polymers, or mixtures thereof. Such non-conducting polymers and copolymers may have a glass transition temperature (T_{g}) of from -150° C to 300° C. Typically T_{g} values range from 25° C to 200° C, more typically from 35° C to 100° C. Thixotropic polymers have strong intermolecular attractions at low shear rates of 0 to 5 s⁻¹ and low intermolecular attractions at high shear greater than 50 s⁻¹. Examples of suitable thixotropic polymers include, but are not limited to, poly(alkyl)acrylics such as poly(meth)acrylics, polyvinyl alcohols, polyesters, polyurethanes, and polyaminoacrylates. Examples of suitable amorphous thermoplastic polymers include, but are not limited to, polyamideimide, polyethersulfone, polyetherimide, polyarylate, polysulfone, polyamide, polymethylmethacrylate, polyvinylchloride, acrylonitrile butadiene styrene, polystyrene, and polycarbonate. Examples of suitable semi-crystalline polymers include, but are not limited to, polyehteretherketone, polytetrafluoroethylene, polyamide 6,6, polyamide 11, polyphenylene sulfide, polyethylene terephthalate, polyoxymethylene, polypropylene, high density polyethylene and low density polyethylene.

Many of the waxes and polymers described above are commercially available or may be synthesized by various methods know in the art or described in the literature.

Polymers and copolymers may be used neat, i.e. free of admixture or dilution, provided they have the desired melting temperature, viscosity and pseudoviscosity. Adjuvants, as described below, may be mixed with the polymers or copolymers to provide the desired melting temperature, viscosity and pseudoviscosity. Two or more polymers or copolymers may be mixed together in amounts each ranging from 1 wt% to 99 wt%, or such as from 5 wt% to 95 wt%, or such as from 15 wt% to 85 wt% of the barrier composition. For example, two or more thermoplastic polymers may be mixed together, or two or more thixotropic polymers may be mixed together. Also, one or more thixotropic polymers may be mixed with one or more thermoplastic polymers each in amounts of from 1 wt% to 99 wt%, or such as from 10 wt% to 90 wt%, or such as from 20 wt% to 80 wt% of the barrier composition. Optionally, adjuvants may be added to the compositions.

Waxes also may be employed neat, or one or more waxes may be combined in the same proportions as described above for two or more polymers. Additionally, one or more of the waxes may be mixed with one or more of the polymers described above to form a repellent barrier composition having a desired melting temperature, viscosity and pseudoviscosity. Waxes may be mixed with one or more polymers in amounts of 1wt% to 99 wt% wax and 1wt% to 99 wt% of polymer, or such as from 10 wt% to 90 wt% wax and 10 wt% to 90 wt% polymer, or such as from 20 wt% to 80wt% wax and 20 wt% to 80 wt% polymer. Optionally, adjuvants may be added to the wax and polymer mixtures.

In addition to waxes and non-conductive polymers, repelling barrier compositions also may include adjuvants such as plasticizers or film forming agents, thickeners, and thixotropic agents, solvents or diluents, dyes, stabilizers, cross-linking monomers and oligomers, surfactants, fillers, antioxidants, elastomers, photoinitiators, and photoacid generators (PAG).

Plasticizers may be employed in amounts of from 1 wt% to 99 wt%, or such as from 5 wt% to 50 wt%, or such as from 10wt% to 30 wt% of the barrier composition. Examples of suitable plasticizers include, but are not limited to, ethylene vinyl acetate, phthalate esters such as dibutylphthalate, diheptylphthalate, dioctylphthalate, and diallylphthalate, glycols such as polyethyleneglycol, and polypropyleneglycol, glycol esters such as triethyleneglycoldiacetate, tetraethyleneglycoldiacetate, and dipropyleneglycoldibenzoate, phosphate esters such as tricresylphosphate, and triphenylphosphate, amides such as p-toluenesulfoneamide, benzenesulfoneamide, and N-n-butylacetoneamide, aliphatic dibasic acid esters such as diisobutyladipate, dioctyladipate, dimethylsebacate, dioctylazelate, and dibutylmalate, citrates such as triethylcitrate, tributylcitrate, triethylacetylcitrate, triethylacetylcitrate, tri-n-propylacetylcitrate, and tri-n-butylacetylcitrate, butyllaurate, dioctyl-4,5-diepoxycyclohexane-1,2-dicarboxylate, and glycerinetriacetylesters. Mixtures of the plasticizers may be used.

Photoinitiators may be used to form UV curable polymer compositions, which upon exposure to actinic radiation increase in viscosity. Any photoinitiator, which is activated by actinic radiation, may be used. Photoinitiators may be included in amounts of from 0.01 wt% to 20 wt%, or such as from 0.5 wt% to 10 wt%, or such as from 1 wt% to 5 wt% of the barrier composition. Examples of suitable photoinitiators include, but are not limited to, hexaarylbiimidazoles, benzophenones, and Michler's ketone. Other photoinitiators are well known in the art and the literature of which many are commercially available. While not being bound by theory, actinic radiation is believed to cause the formation of free radicals from photoinitiators, which in turn react with unsaturated groups or compounds in the barrier composition leading to an exponential increase in molecular weight of polymers in the composition and an increase in the viscosity of the composition.

Any suitable thickener may be used. Many conventional thickeners are well known in the art. Thickeners may be included in amounts of from 0.05 wt% to 10 wt% or such as from 1 wt% to 5 wt%. Examples of suitable thickeners include, but are not limited to, bentonite and other silicate-type materials, aluminum, calcium, and zinc salts of fatty acids, such as lauric or stearic acid, and fumed silicas, or mixtures thereof.

Any suitable monomers or oligomers having α,β-unsaturation also may be included in the composition. Such monomers and oligomers are included in amounts of from 0.5 wt% to 20 wt%, or such as from 5 wt% to 10 wt% of the composition. Examples of typical monomers are (meth)acrylate and (meth)acrylic acid and there derivatives.

Any suitable solvent or diluent may be employed such as water or one or more organic solvents. Mixtures of water and one or more organic solvent may be employed. Solvents may be employed in amounts of from 1 wt% to 99 wt% or such as from 5 wt% to 30 wt%, or such as from 10 wt% to 20 wt% of the barrier composition.

Dyes and UV stabilizers may be employed in conventional amounts. Suitable dyes include, but are not limited to, Leuco dyes.

Suitable surfactants include non-ionic surfactants, ionic surfactants and amphoteric surfactants, or mixtures thereof. Surfactants are included in amounts of from 0.5 wt% to 10 wt% or such as from 1 wt% to 5 wt% of the barrier composition.

Acid curatives also may be included to provide the desired viscosity and pseudoviscosity. Acidic cure catalysts include not only substances, which have free carboxyl groups, but also chemicals such as anhydrides, which may produce free carboxyl groups. Other useful catalysts are those having a blocked carboxylic group, which become deblocked at a threshold temperature. Such cure catalysts may be employed at levels of from 0.05 wt% to 15 wt%, or such as from 0.1 to 10 wt%, or such as from 1 wt% to 5 wt%. Examples of such catalysts include Nacure® catalysts from King Industries. Such catalysts are blocked acid catalysts. Other suitable catalysts include blocked sulfonic and phosphoric acid types.

Examples of suitable photoresists, which may be employed as a repelling barrier, include both negative-acting, positive-acting, dry film and liquid photoresists including waterborne photoresists. Typically, negative-acting and positive-acting liquid photoresists such as waterborne photoresists. More typically negative-acting photoresist is used. Exposure of negative-acting photoresist to actinic radiation hardens the photoresist to provide a barrier. Negative-acting photoresist may be applied as a dry film or as a liquid, such as a waterborne photoresist. Photoresists used as repellent barrier compositions have polymer binders including one or more of the thixotropic or thermoplastic polymers described above. Conventional polymer binders also may be included. Polymer binders compose from 20 wt% to 95 wt% or such as from 30 wt% to 80 wt% of the photoresist. Thixotropic or thermoplastic polymers compose from 10 wt% to 80 wt% or such as from 20 wt% to 60 wt% of the polymer binder. Mixtures of thixotropic and thermoplastic polymers also may be used in photoresists.

Photoresists employed as barriers also include conventional components such as photoinitiators, rheological agents, plasticizers, UV stabilizers, dyes, thickeners, cross-linking agents such as unsaturated monomers and oligomers, fillers, and other conventional components well known in the art. Such components are included in conventional amounts, which are well known in the art. Viscosities and melting temperatures as well as T_{g} values of the photoresists may be adjusted by employing the thixotropic and thermoplastic polymers described above. Minor experimentation may be used to arrive at the desired properties. Typically, such photoresists are exposed to actinic radiation prior to applying the radiant energy sensitive material, which forms the pattern.

In another embodiment the two or more waxes or two or more non-conducting polymers or one or more waxes and one or more non-conducting polymers may be applied separately by ink-jet such that they do not contact or mix with each other until they reach the substrate. Mixing upon contact causes a rapid increase in the viscosity of the mixed waxes or non-conducting polymers such as from a viscosity of from less than 50 cp to a mixture viscosity of greater than 10,000. Typically, one or more thixotropic polymers are employed along with one or more waxes or one or more thermoplastic polymers. Upon contact between one or more waxes or one or more polymers, a gel may form. Gel formation typically occurs when one of the components is an acid and the other is a base. Acids and bases are defined according to the Lewis acid and base definition. An example of a base is a polyamide or polyamine. An example of an acid is a wax or polymer with acid reactive groups such as carboxyl groups. Such acids have acid numbers of from 20 gm of potassium hydroxide (KOH) or greater or such as from 30 gm to 150 gm of KOH. The thixotropic polymer may compose from 5 wt% to 70 wt%, or such as from 10 wt% to 50 wt% or such as from 20 wt% to 40 wt% of the mixture. Viscosity changes may occur over a period of less than 2 second, or such as from 1 to 0.05 seconds or such as from 0.5 to 0.1 seconds. Viscosity may be measured using shear viscometers, which are commercially available. As shear is applied, viscosity is recorded overtime.

Repellent barrier compositions applied from an ink-jet having viscosities of from 5 cp to 25 cp, or such as from 5 cp to 20 cp or such as from 10 cp to 15 cp at temperatures of 25° C or greater, or such as 50° C to 250° C, or such as from 100° C to 150° C. Pseudoviscosities of barrier compositions are greater than 10,000 cp, or such as from 20,000 cp to 100,000 cp, or such as from 30,000 cp to 70,000 cp at temperatures below 25° C, or such as 15° C to 20° C. Repellent barrier compositions are thin (5 cp to 25 cp) at high shear such as at the nozzle of an ink-jet apparatus and are thick at low shear (greater than 10,000 cp) after application on a substrate. Such barrier compositions may have a solids content of at least 60 wt%, or such as from 70 wt% to 100 wt%, or such as from 80 wt% to 95 wt%.

Repellent barrier compositions also may be applied to a substrate by employing roller coating methods. Roller coating methods exemplify acid-base gel formation for forming a repellent barrier on a substrate. Such reactions may be neutralization reactions, which form high molecular weight gels of pseudoviscosities greater than 10,000 cp. Acids and bases, within the scope of the invention, are Lewis acids and bases. One or more bases or alternatively one or more acids may be roller coated on a substrate where the pattern is to be formed using conventional roller coating procedures and apparatus. When one or more bases are roller coated, one or more acids are selectively applied to the base coated substrate to form a gel where the acids contact the bases. Alternatively, when one or more acids are roller coated on the substrate, one or more bases are selectively applied to the acid coated substrate to form a gel. Application of the acids or bases to the roller coated substrate may be by any suitable method such as by ink-jetting. If application is performed by ink-jet, the ink-jetting apparatus is programmed by suitable computer programs to selectively apply the acids or bases to the coated substrate.

The gel, which has a pseudoviscosity of greater than 10,000 cp, acts as the repellent barrier. The ungelled portions of the substrate are removed leaving spaces or channels for the application of photosensitive materials. The ungelled portions may be removed with any suitable base or acid. Examples of suitable bases include 1 wt% sodium carbonate or potassium carbonate. Examples of suitable acids include 0.5 wt% citric and tartaric acid. Such bases and acids are employed at temperatures of from 25° C to 35° C, or such as from 28° C to 32° C. Such photosensitive materials include, but are not limited to, photoresists and photosensitive inks. The repellent barrier may then be removed leaving a pattern. The substrate may then be further processed using conventional methods to form the final article.

Any Lewis acid-base pair, which forms a gel having a pseudoviscosity of greater than 10,000 cp may be employed. Acids and bases also include compounds such as waxes, polymers and copolymers as well as photoresists, which have acid or base functional groups. Examples of suitable bases include, but are not limited to, amines, polyamines, polyamides, urea and its derivatives, ammonia, and ammonium hydroxide. Examples of suitable acids include, but are not limited to, carboxylic acids, polymers and copolymers with carboxyl functional groups such as poly(alkyl)acrylics, and compounds containing acidic alcohol groups.

Repelling barrier compositions also may be applied to a substrate by spin coating the barrier on a substrate. As in ink-jetting the viscosity of the barrier composition ranges from 5 cp to 25 cp, and has a pseudoviscosity of greater than 10,000 cp after it is spin coated onto the substrate. Methods and apparatus for spin coating are well known in the art.

Another method of applying the repellent barrier is electrostatically. The substrate is coated with an electrostatically charged solution. An applicator gun is used to apply temporary charge on the solution and is dispersed in the direction of the substrate. Repelling barrier materials may then be selectively deposited on the charged substrate by ink-jet application. Repelling barrier materials selectively deposited have a net opposite charge from the net charge on the substrate. Typically, such barrier materials have net negative charges due to such functional groups such as carboxyl groups, acidic hydroxyl groups, sulfate, and phosphate groups on molecules in the barrier material. Charges may be induced on barrier materials by applying a suitable voltage to the materials. Methods of applying such charges are well known in the art. Resists deposited in the spaces and channels formed by the barrier material may be plating resists.

After the repelling barrier is applied to a substrate forming spaces or channels, a radiant energy sensitive material is applied in the spaces or channels outlined by the barrier. The radiant energy sensitive material applied in the spaces and channels is repelled by the barrier composition physically, electrolytically, chemically, or by combinations thereof such that the radiant energy sensitive material does not react with the barrier material to form another chemical composition, is not miscible with the barrier material, is repelled by the barrier material due to similar net charges, or have different viscosities such that they do not intermix. Typically, the repelling barrier composition has a greater solids content then the radiant energy sensitive material at the time the radiant energy sensitive material is applied to the substrate. Ratios of solids content of barrier material to radiation sensitive material may range from 1.05 to 10, or such as 2 to 8 or such as from 4 to 6.

Physical repelling between a barrier composition and a radiant energy sensitive material may be due to the barrier composition being hydrophobic and a resist being hydrophilic. For example the barrier composition may contain amounts of hydrophobic wax such as from 20 wt% to 100 wt%, or such as from 40 wt% to 80 wt%, or such as from 50 wt% to 70 wt% in the composition. Hydrocarbon waxes are one example of a wax, which provides the desired hydrophobic properties. An example of a resist, which may be used with the barrier composition, is a waterborne photoresist. Alternatively, the barrier composition is hydrophilic and the resist is hydrophobic. For example, the barrier may compose polymer or copolymers having hydroxyl, ester, ether, or carboxyl functionalities in amounts sufficient to provide hydrophilicity. Such polymers or copolymers are typically 10% to 70%, or such as from 20% to 60% substituted with such functionalities. An example of a suitable resist, which may be used with the barrier composition, is a liquid photoresist having an organic solvent.

Repelling between the barrier and the radiant energy sensitive material also may be due to net electrostatic charges on the compositions. A barrier composition and a radiant energy sensitive material having net like charges repel each other. Examples of suitable barrier compositions and radiant energy sensitive materials have numerous polar or charged functional groups. Such charged functional groups include, but are not limited to, sulfate, phosphate, carboxyl, quaternary ammonium group N(R)₄⁺ where R is an organic group, or an amine salt such as R-N(H)₃⁺. Polar or charged functional groups typically include 20% to 80%, or such as from 30% to 50% of the functional groups on the barrier composition and resist material.

Chemical repelling means that neither the barrier composition nor the radiant energy sensitive material has the proper functionalities for the barrier composition and the radiant energy sensitive material to react. Also the environmental conditions are not suitable for reactions to occur. Such environmental conditions include, but are not limited to, temperatures, pressures as well as diluent. Such barrier compositions and radiant energy sensitive materials have less than 20%, or such as from 1% to 15% functional group substitutions on their polymers or copolymers. Examples of such reactive functional groups include, but are not limited to, hydroxyl, carboxyl, carbonyl, amino, amine, ketyl, sulfate and phosphate groups.

After the radiant energy sensitive material is applied the repelling barrier is removed leaving the resist on the substrate with a pattern. The barrier may be removed by any suitable method known in the art. For example, barriers may be removed by a suitable developer solution. Such developer solutions include, but are not limited to, aqueous alkaline solutions such as aqueous solutions of lithium, sodium and potassium hydroxide or base-reacting alkali metal salts or weak acids such as lithium, sodium, and potassium carbonates and bicarbonates. Such solutions contain alkaline agents in amounts of from 0.001 wt% to 10 wt%, or such as from 0.5 wt% to 3 wt%.

Other.suitable developer solutions include, but are not limited to, primary amines such as benzyl, butyl, and allyl amines, secondary amines such as dimethyl amine, and benzyl methyl amine, tertiary amines such as trimethylamine, and triethylamine, primary, secondary and tertiary hydroxyamines, cyclic amines, water-soluble basic salts such as the carbonates and bicarbonates of amines, and ammonium hydroxide. Mixtures of liquid hydrocarbons and their corresponding alcohols also may be employed.

After the barrier is removed, a pattern is left on the substrate. The patterned substrate may be further processed or the patterned substrate may be the completed article. Typically, if the patterned substrate is a textile the patterned substrate is the complete article. In such embodiments the radiant energy sensitive material is ink. If the patterned substrate is for an electronic device, further processing may be done.

Patterned substrates employed in electronic articles may be further processed by depositing one or more metal layers in the pattern formed by the resist. Metal or metal alloys may be deposited electrolessly, electrolytically, and by immersion. Any suitable electroless, electrolytic, and immersion bath and method may be employed to deposit metal or metal alloy layers. Many such baths are commercially available or may be readily made from the literature. Also many methods are known in the art and from the literature. Metals, which may be deposited include, but are not limited to, noble and non-noble metals and their alloys. Examples of suitable noble metals include, but are not limited to, gold, silver, platinum, palladium and their alloys. Examples of suitable non-noble metals include, but are not limited to, copper, nickel, cobalt, lead, iron, bismuth, and their alloys.

Substrates containing metal or metal alloy deposits may be joined together, such as by lamination, to form multi-layer printed circuit boards. Various lamination processes are known in the art or described in the literature. One problem associated with the manufacture of multi-layer printed wiring boards is registration. Registration is the relative position of one or more printed wiring patterns or portions thereof with respect to desired locations on a printed wiring boards or another patter on the other side of the board. One of the challenges in the manufacture of multi-layer printed wiring boards is to obtain adequate innerlayer registration. Internal features must be registered accurately to each other, and they must be accurately registered to any drilled holes. Hole-to-innerlayer misregistration creates two potential reliability problems: failure of the hole to line connection and shorts between holes and isolated conductors. Misregistration of internal layers also increases electrical resistance and decreases conductivity. Severe misregistration creates an open-circuit condition, a complete loss of continuity.

Methods of the present invention address the misregistration problem. For example application of the repellent barrier composition by ink-jet permits accurate deposition of the barrier composition at selective points on a substrate. Such selective deposition may be repeated with reliable accuracy for multiple substrates because ink-jets may be digitally programmed for repetitive application. Further, the viscosity of the barrier compositions and their ability to repel radiant energy sensitive material applied in the spaces, holes or channels formed by the barrier directs radiant energy sensitive materials into proper areas at the desired thickness on each substrate of the laminate, thus reducing or eliminating misregistration between substrates of a multi-layer laminate.

In an exemplary embodiment repellent barrier compositions may be employed to selectively deposit solder mask on a substrate such as a printed circuit board. Solder mask is a hard permanent layer of non-conductive material, which covers the surface of a printed circuit board encapsulating circuit traces of the printed circuit. Repellent barrier material may be selectively applied to the printed circuit board such that the barrier material outlines the circuit traces. Selective application of the barrier composition may be done by ink-jetting. If the repellent barrier composition is a photoresist or a UV curable polymer composition, the barrier is exposed to actinic radiation to harden it before applying the resist material, which composes the solder mask. The resist material applied within the spaces or channels formed by the barrier composition covers the circuit traces. The barrier composition repels the resist physically, electrolytically, chemically, or by combinations thereof. The resist is then exposed to actinic radiation to harden the resist to form a solder mask. The barrier composition is then removed using a suitable developer and a patterned solder mask is left coating the circuit traces. The method eliminates etching the solder mask as is done in many conventional methods and reduces chemical waste created by etching of solder mask as in conventional methods.

Methods of the invention are more efficient then many conventional processes since fewer steps are needed such as in the formation of solder mask. As described above the repellent barrier composition permits selective deposition of solder mask, thus the substrate need not be completely coated with the solder mask. This eliminates undesirable etching steps for removing unwanted portions of the solder mask. This in turn reduces the amount of waste created by the etching. Such waste may present a hazard to the environment, thus such methods of the invention for applying a solder mask are more environmentally friendly than many conventional processes. Additionally, reducing the number of steps and chemical waste increases process efficiency.

For example, in a conventional liquid photoimageable resist process for making a solder mask, data is generated then plotted by a worker to determine a desired pattern for a phototool. A second worker then develops the film for the phototool and a third worker inspects and punches the film. A fourth worker cleans a substrate on which the phototool is used to form the solder mask. He then coats the substrate with a resist such as a liquid photoimageable solder mask material, and then dries the liquid photoimageable solder mask material. A fifth worker applies the phototool to the dried photoimageable material and exposes it to actinic radiation. A sixth worker develops away portions of the photoimageable material. A seventh worker cures the remaining portions of the photoimageable material on the substrate thermally or by UV radiation.

In contrast, methods of the present invention reduce the number of steps from nine to eight, and reduce the staffing from 7 workers to 6.5. For example, data is generated and plotted to determine the pattern, which the repellant barrier material is to have on the substrate. One worker generates and plots the data. A worker performing two separate tasks, one related to the cleaning step of the substrate, and then another task unrelated to the cleaning step, thus 0.5 workers. Two workers ink jet the repellant barrier material on the substrate, and another worker coats and dries the liquid photoimageable solder mask material on the substrate. An additional worker exposes the photoimageable solder mask material to actinic radiation and then develops away the repellant barrier material. The last worker cures the photoimageable material thermally or by UV light. Accordingly, the ink jet methods are more efficient then many conventional methods. The ink jet methods reduce staffing and reduce the number of process steps.

The repellant barrier compositions and methods of applying it may be practiced on any suitable substrate where the barrier compositions adhere and retain radiant energy sensitive materials within the spaces, holes or channels formed by the barrier. Examples of suitable substrates include, but are not limited to, metals, dielectrics such as ceramics, glass, plastics, epoxy/fiberglass materials as in FR4 printed wiring boards, textiles and fabrics as well as cellulose derivatives such as paper.

The foregoing methods of applying a repelling barrier to a substrate and making articles are not exhaustive. The present invention encompasses other apparatus and processes for applying a repellent barrier composition to a substrate and making articles, which may be ascertained by a person of skill in the art by the teachings of the present specification.

### Example 1

### Hot Melt Formulation

A solder mask-forming photoimageable composition is formulated as follows:

| **Component** | **Wt%** |
|---|---|
| Acrylic resin (binder) acid no. 200 (monomer content 30 wt% acrylic acid, 70 wt% styrene) | 23 |
| 1,8 diaza-bicyclo-(5,4,0)-undecene-7-phenol salt | 1 |
| Equal weight mixture of (a) hydroxyethyl methacrylate, (b) bisphenol A diacrylate, and (c) dipentaerithritol monohydroxy pentaacrylate | 22 |
| 2,2 dimethyl-2-phenyl-acetophenone | 3 |
| Liquid cycloaliphatic monoepoxy, epoxy equiv. 120-130 | 42 |
| Methylated melamine | 9 |
| Total | 100 |
| Leveling agent | 1 |
| Pigment (phthalocyanine green) | 1 |
| Fumed silica | 2 |
| **Micro talc** | **14** |
| Ground polyethylene | 1 |
| Fillers | As needed |

The above formulation is dissolved in a solvent system of 50:50 (by volume) ethylene glycol butylether acetate/propylene glycol monomethyl ether to a 70% solids level.

A hot melt formulation of 100 wt% polypropylene is placed in the reservoir of a Drop-On-Demand ink-jet apparatus. The ink-jet apparatus is programed for application of the polypropylene around circuit traces of epoxy/fiberglass printed wiring boards. A standard CAD computer program for generation of tooling data is used. The polypropylene is jetted from the ink-jet apparatus using a high pressure technique, i.e. 50 psi.

The polypropylene is forced from the reservoir at 50 psi and forced out through ink-jet nozzles having orifices of 70 µm in diameter. The viscosity of the polypropylene drops is expected to be from 5 cp to 20 cp. The temperature of the viscous polypropylene is 180° C. The polypropylene adheres to the printed wiring boards forming a barrier around the circuit traces on each boarad. The ambient temperatures around the printed wiring boards are 20° C. The drops of polypropylene cool to the ambient temperature and the pseudoviscosity of the polypropylene is expected to be greater than 10,000 cp.

The photoimageable composition described above is applied on a Ciba Geigy Probimer® curtain coating line including a curtain coater and drying apparatus. Application of the photoimageable composition is at 20° C to the printed wiring boards moving at 120 meters/minute. The photoimageable composition is supplied at a rate sufficient to provide a film (after drying) of 1 mil thick in channels outlined by the polypropylene barrier. Drying is at 145° C for 2 minutes. The polypropylene barrier is expected to repel the photoimageable compositon such that the polypropylene and the photoimageable composition do not react chemically and are not miscible.

After drying the photoimageable composition is exposed to actinic radiation to harden it. The polypropylene barrier is then removed using a 60:40 (by volume) mixture of hexanol and hexane at 20° C.

After removal of the barrier, a solder mask pattern is left on the printed wiring boards coating the circuit traces. Optionally, the printed wiring boards may be further processed by laminating the boards together to form multi-layer printed wiring.

### Example 2

### Hot melt Formulation

A hot melt formulation is prepared by blending polystyrene and ethylene vinyl acetate at a temperature of 150° C in a standard laboratory blending apparatus such that the final formulation is composed of 60 wt% polystyrene and 40 wt% ethylene vinyl acetate. Solids content is 100 wt%.

The blend is then placed in a reservoir of a Drop-On-Demand ink-jet apparatus. The ink-jet apparatus is programmed to apply the blend to form a barrier around circuit traces of printed circuit boards made of epoxy/fiberglass. The blend is ink-jetted at a temperature of 175° C at a high pressure of 20 psi. The blend is jetted from nozzles having orifice diameters of 40µm and the viscosity of the blend is expected to be from 5 cp to 25 cp.

The printed circuit boards are at an ambient temperature of 25° C, when the blend contacts and adherers to the boards, the blend cools to the ambient temperature and its pseudoviscosity is expected to be greater than 10,000 cp. The pseudoviscosity is measured with a commercially available shear viscometer.

After the blend is applied to the printed circuit boards to form a barrier around the circuit traces, the photoimageable composition as described in Example I is applied by curtain coating according to the same procedure as in Example 1 to channels formed by the barrier. The barrier is expected to repel the photoimageable composition such that the blend does not react chemically react with the photoimageable composition nor is it miscible with the photoimageable composition.

After the photoimageable composition is dried it forms a film 2 mils thick, and then it is exposed to actinic radiation to harden it. The barrier is then removed with a developer composed of dimethyl amine. The printed circuit boards now have a solder mask pattern, which covers and protects the circuit traces of the boards.

The printed circuit boards may be further processed, such as by laminating the boards together to form multi-layer printed circuit boards. The multi-layer printed circuit boards may be employed in electronic devices.

### Example 3

### Thixotropes

A photoimageable composition is prepared as follows:

| **Component** | **Wt%** |
|---|---|
| Tris(2-hydroxyethyl) isocyanurate triacrylate | 20 |
| Methylated melamine | 3 |
| Epoxy methacrylate resin | 7 |
| Diacrylate ester of a bisphenol A epoxy resin | 7 |
| Epoxy cresol novolac resin, epoxy eq. 235 | 25 |
| Bisphenol A epoxy resin, epoxy eq. 575-685 | 24 |
| 5-(2,5-dioxytetrahydrofuryl)-3-methyl-3-cyclohexane-1,2-dicarboxylic anhydride | 9 |
| 2,2-dimethoxy-2-phenyl acetophenone | 2 |
| 2-methyl-1-[4-(methylthio)phenyl}-2-(4-morpholinyl)-1-propanone isopropylthioxanthone | 3 |
| Total | 100 |
| Modaflow | 1 |
| Silicone surface additive | 1 |
| Pigment (Penn Green) | 1 |
| Fumed silica | 2 |
| Inhibitor | 0.1 |
| Ethyl-3-ethoxy propionate | As needed |

Polymethacrylic acid and polyvinyl alcohol are blended together in a standard laboratory blending apparatus at a temperature of 30° C until a uniform blend is obtained. Ethylene vinyl acetate is then added to the blend and uniformly mixed with the polymer blend at a temperature of 30° C. The final mixture is composed of 70 wt% polymethacrylic acid, 10 wt% polyvinyl alcohol and 20 wt% ethylene vinyl acetate to form a thixotropic composition.

The thixotropic composition is placed in the reservoir of a Drop-On-Demand ink-jet apparatus. The thixotropic composition is delivered to a series of nozzles at a pressure of 5 psi for application to printed circuit boards. The ink-jet apparatus is programmed for selectively depositing the thixotropic composition on printed circuit boards such that the thixotropic composition forms a barrier around circuit traces on the boards. The thixotropic composition is at 150° C and is expected to have a viscosity of 5 cp to 20 cp as it leaves the nozzles of the apparatus. The nozzles have an orifice diameter of 60 µm.

The printed wiring boards are at an ambient temperature of 22° C. When the drops of thixotropic composition contact the surface of the boards, the pseudoviscosity of the thixotropic composition is expected to be greater than 10,000 cp.

The photoimageable composition is applied as a wet film via a curtain coating process. A sufficient amount of the photoimageable composition is applied in the channels formed by the barrier formed by the thixotropic composition to form a dry film thickness over the copper circuit traces of 2 mils. The photoimageable composition is 60% solids.

The photoimageable composition is dried at 90° C for 15 minutes and then cooled to 22° C. The photoimageable composition is exposed to UV actinic radiation at an exposure energy level of 350 mJ/cm². The barrier is then removed using a developer composed of benzyl methyl amine.

The printed circuit boards with the solder mask pattern may be further processed to form multi-layer laminated boards and used in electronic devices.

### Example 4

### Gel Formation

A suspension of polyaminotriazole in acetone is hot roll laminated on printed wiring boards having copper circuitry. A film of 0.5 mils is formed on the boards.

A suspension of polyacrylic acid, which contains 80 wt% polyacrylic acid and 20 wt% methyl ethyl ketone, is placed the reservoir of a Drop-On-Demand ink-jet apparatus. The apparatus is programmed such that it deposits drops of the suspension to form a barrier around the copper circuitry of the printed wiring boards. The suspension is at a pressure of 30 psi in the ink-jet apparatus. Drops of the suspension are selectively deposited on the printed wiring boards from nozzles having orifice diameters of 75 µm. The temperature of the drops as they leave the nozzles is 125° C and is expected to have a viscosity of 5 cp to 20 cp.

When the drops contact the polyaminotriazole coated printed wiring boards, an acid base reaction is believed to occur between the carboxyl groups of the polyacrylic acid and the amine salt groups of the polyaminotriazole to form a high molecular weight gel/salt. The reaction to form the gel/salt is believed to occur in less than two seconds. The pseudoviscosity of the gel/salt is expected to be greater than 10,000.

Portions of the polyaminotriazole, which are not exposed to the polyacrylic acid are removed using a developer solution of 1 wt% aqueous sodium bicarbonate. After the polyaminotriazole is removed from the boards, a photoimageable ink composition is applied into the channels and spaces outlined by the barrier gel/salt.

A photoimageable ink composition is prepared having a composition as follows:

| **Component** | **Wt%** |
|---|---|
| Polymerizable Material (hydroxyedthyl methacrylate and trimethylol propane triacrylate in a 1:1 ratio) | 28 |
| Polyester Binder (a condensation polymer of propylene glycol and phthalic anhydride having a molecular weight of 3000-5000 and an acid number of 60-90) | 35 |
| Itaconic Acid | 2.5 |
| Benzoin isobutyl Ethere | 4 |
| Filler (barium sulfate) | 29 |
| Leveling Agent (Modaflow) | 0.5 |
| Benzotriazole | 0.5 |
| Pieslo blue Pigment | 0.5 |

The photoimageable ink composition is applied as a wet film via a curtain coating process. A sufficient amount of photoimageable ink is applied in the channels formed by the gel/salt barrier to form a dry film thickness of 2 mils thick over the copper circuitry. The gel/salt barrier is expected to repel the photoimageable ink composition such that the gel/salt barrier does not chemically react with the photoimageable ink nor is it miscible with the photoimageable ink. The gel/salt barrier directs the photoimageable ink composition into the spaces and channels.

The photoimageable ink composition is then exposed for 5 minutes to a medium pressure, 200 watt mercury vapor lamp. After exposure the ink composition is hardened to form a solder mask. The gel/salt barrier is then removed using a developer solution of sodium hydroxide.

The patterned solder mask coating the copper circuitry may be further processed to form laminated multi-layer circuit boards. The boards may be employed in electronic devices.

### Example 5

### UV Curable Polymer Mixture

A UV curable polymer is formed as follows:

| **Component** | **Wt%** |
|---|---|
| Polyethylene terephthalate | 40 |
| Polyvinyl alcohol | 25 |
| Trimethylolpropane diacrylate | 10 |
| Polyethylene glycol diacrylate | 5 |
| Ethyl Michler's Ketone | 2 |
| Benzophenone | 1 |
| Thiodiethylene bis-(3,5-di-tert-butyl-4-hyddroxy hydrocinnamate) | 0.5 |
| Ethylene vinyl acetate | 1.5 |
| Adhesion promoters | 0.5 |
| Leuco Dyes | 0.5 |
| Methyl ethyl Ketone | 14 |

Polyethylene terephthalate and polyvinyl alcohol are each prepared separately by free radical polymerization using known methods in the literature. After polymerization of each of the polymers, the remainder of the components is blended together using known methods disclosed in the literature. The viscosity of the blend is expected to be from 5 cp to 20 cp at room temperature (18° C to 25°C).

The UV curable polymer mixture is placed into the reservoir of a Drop-On-Demand ink-jet. The mixture is selectively deposited on printed wiring boards by means of the ink-jet apparatus to form a barrier around copper circuitry. The mixture is deposited onto the boards via nozzles with diameters of 55 µm. During application of the mixture actinic radiation in the form of UV light is applied to the printed circuit boards such that the mixture is cured when it contacts the boards. Exposure of the mixture to UV light during application causes curing of the mixture such that its pseudoviscosity is expected to be greater than 10,000 cp.

A photoimageable composition having the formulation as in Example 1 is curtain coated on the printed wiring boards by the same method as described in Example 1. The photoimageable composition forms a 1 mil thick film after drying in the channels formed by the cured mixture. The cured mixture repels the photoimageable composition such that there is no chemical reaction between the photoimageable composition and the cured mixture nor is it miscible with the cured mixture. The photoimageable composition is then exposed to UV actinic radiation to form a hardened solder mask.

The cured polymer mixture is removed with a developer solution. A tetramethyl ammonium hydroxide is used to remove the cured polymer mixture. The printed wiring boards are left with a patterned solder mask. The boards may be further processed to form laminates of multi-layer circuit boards.

## Claims

1. A method comprising:
a) applying a repelling barrier composition selectively to a substrate;
b) applying a radiant energy sensitive material to the substrate in spaces formed by the repelling barrier composition; and
c) removing the repelling barrier composition to form a pattern on the substrate.

2. The method of claim 1, wherein the repelling barrier composition is applied to the substrate by ink-jetting.

3. The method of claim 1, wherein the repelling barrier composition has a viscosity of from 5 cp to 25 cp.

4. The method of claim 1, wherein the repelling barrier composition has a pseudoviscosity of greater than 10,000 cp.

5. The method of claim 1, further comprising depositing one or more metal or metal alloy layers in spaces formed by the pattern.

6. A method comprising:
a) roller coating a substrate with a base;
b) selectively applying an acid to the base to form a repelling barrier composition;
c) removing unreacted base from the substrate;
d) applying a radiant energy sensitive material to spaces formed by the removal of the unreacted base and outlined by the repelling barrier composition; and
e) removing the repellent barrier composition to form a pattern.

7. The method of claim 6, wherein the acid is applied by ink-jetting.

8. The method of claim 6, wherein the repelling barrier composition is a gel or gel/salt.

9. A method comprising:
a) roller coating an acid on a substrate;
b) selectively applying a base on the acid coated substrate to form a repelling barrier composition;
c) removing unreacted acid from the substrate;
d) applying a radiant energy sensitive material to spaces formed by removal of the unreacted acid and outlined by the repelling barrier composition; and
e) removing the repellent barrier composition to form a pattern.

10. A composition comprising one or more waxes, or one or more polymers, or mixtures thereof, which physically, electrostatically, chemically or by combinations thereof repel radiant energy sensitive materials.
